Europäisches Patentamt

European Patent Office

Office européen des brevets

(11) Veröffentlichungsnummer: **0 455 974 A2**

## (12) EUROPÄISCHE PATENTANMELDUNG

(21) Anmeldenummer: 91104587.0

(22) Anmeldetag: 23.03.91

(51) Int. Cl.⁵: **H03J 3/24**, H03G 3/20

(30) Priorität: 11.04.90 DE 4011650

(43) Veröffentlichungstag der Anmeldung:
13.11.91 Patentblatt 91/46

(84) Benannte Vertragsstaaten:
ES FR GB IT

(71) Anmelder: Licentia Patent-Verwaltungs-GmbH
Theodor-Stern-Kai 1
W-6000 Frankfurt/Main 70(DE)

(72) Erfinder: Brodowski, Rüdiger, Dipl.-Ing.
Roedernstrasse 29 B
W-1000 Berlin 28(DE)
Erfinder: Erat, August, Dipl.-Ing.
Treuenbrietzer Strasse 19
W-1000 Berlin 26(DE)

(74) Vertreter: Lertes, Kurt, Dr. et al
Licentia Patent-Verwaltungs-GmbH
Theodor-Stern-Kai 1
W-6000 Frankfurt/M 70(DE)

(54) **Regelschaltung für einen Überlagerungsempfänger.**

(57) Eine Regelschaltung für eine elektronisch einstellbare Vorstufe(2) eines Überlagerungsempfängers mit einem Prozessor(21) soll ein in der jeweiligen Empfangssituation günstigstes Nutzsignal/Störsignal-Verhältnis gewährleisten. Es sind hierfür im Signalweg wenigstens zwei Pegelmesser(16,17 bzw. 18) vorgesehen. Der Prozessor(21) steuert ein Dämpfungsglied(11). Bei einem bezogen auf den Pegel an einem hinteren Pegelmesser (17 bzw. 18) hohen Pegel am vorderen Pegelmesser(16) stellt er eine Dämpfung am Dämpfungsglied(11) so hoch ein, daß sich ein günstiges Nutzsignal/Störsignal-Verhältnis ergibt. Beim etwa gleichen Pegel reduziert er die Dämpfung des Dämpfungsgliedes(11).

FIG.1

EP 0 455 974 A2

Die Erfindung betrifft eine Regelschaltung für eine elektronisch einstellbare Vorstufe eines Überlagerungsempfängers mit einem Prozessor, der über einen Digital/Analog-Wandler die im Signalweg zwischen einer Antenne und einem Zwischenfrequenz-Filter liegende Vorstufe steuert.

Eine derartige Regelschaltung ist in der DE 29 16 171 C2 beschrieben. Dort wird durch vom Mikroprozessor vorgegebenen Daten der Vorkreis abgestimmt. Die Einstellung eines Dämpfungsgliedes in der Vorstufe ist nicht vorgesehen.

Bei einer Vorstufe, deren Schwingkreis eine mittels einer Abstimmspannung abstimmbare Kapazitätsdiode aufweist, ist zur Dämpfung des Eingangspegels ein Dämpfungsglied vorgesehen, um eine Verstimmung durch die Antennen-Wechselspannung zu unterdrücken. Gewöhnlich wird bei einem Zwischenfrequenz-Filter der Pegel gemessen und das Dämpfungsglied wird so gesteuert, daß es ab einem bestimmten Eingangpegel wirkt. Damit ist die auswertbare Nutzsignalstärke beschränkt. Eine Unterscheidung zwischen einer ungestörten Empfangssituation, bei der nur das Nutzsignal vorhanden ist, und einer gestörten Empfangssituation, bei der neben dem Nutzsignal auch Störsignale vorliegen, erfolgt dabei nicht. Damit werden bei einer ungestörten Empfangssituation die Empfangsmöglichkeiten zur Verbesserung des Nutzsignal/Störsignal-Verhältnisses nicht voll ausgeschöpft. Außerdem führen starke Störsignale zu einer unerwünschten Erniedrigung der Dämpfung des Dämpfungsgliedes.

Ein weiterer Nachteil bei mit Kapazitätsdioden abgestimmten Vorstufen besteht darin, daß die Schwingkreise durch die anliegende Störspannung verstimmt werden. Liegt beispielsweise die Nutzsignalspannung im mV-Bereich und die Störsignalspannung im V-Bereich, dann wird die Resonanzfrequenz der Vorkreise so weit verschoben, daß die gewünschte Selektion stark beeinträchtigt wird. Dadurch wird das Störsignal verstärkt weiter verarbeitet, das Nutzsignal jedoch gedämpft.

Aufgabe der Erfindung ist es, eine Regelschaltung der eingangs genannten Art vorzuschlagen, durch die ein in der jeweiligen Empfangssituation günstiges Nutzsignal/Störsignal-Verhältnis erreicht wird.

Erfindungsgemäß ist obige Aufgabe bei einer Regelschaltung der eingangs genannten Art dadurch gelöst, daß im Signalweg wenigstens zwei Pegelmesser liegen, wobei ein vorderer Pegelmesser an einer Stelle geringer Selektion und ein hinterer Pegelmesser hinter dem Zwischenfrequenz-Filter angeordnet ist, daß der Prozessor ein im Signalweg vor dem vorderen Pegelmesser angeordnetes Dämpfungsglied in Abhängigkeit von den Pegeln der Pegelmesser steuert, wobei der Prozessor bei einem bezogen auf den Pegel am hinteren Pegelmesser hohen Pegel an dem vorderen Pegelmesser die Dämpfung des Dämpfungsgliedes so hoch einstellt, daß sich ein günstiges Nutzsignal/Störsignal-Verhältnis ergibt und der Prozessor bei einem bezogen auf den Pegel am hinteren Pegelmesser etwa gleichen Pegel am vorderen Pegelmesser die Dämpfung des Dämpfungsgliedes reduziert.

Dadurch, daß wenigstens zwei Pegelmesser im Signalweg an Stellen unterschiedlicher Selektion vorgesehen sind, kann der Prozessor ermitteln, ob das Eingangssignal gestört oder ungestört ist, d. h. dem Nutzsignal ein mehr oder weniger starkes Störsignal überlagert ist. Ist der Pegel am vorderen Pegelmesser im Vergleich zum Pegel am hinteren Pegelmesser hoch, dann ist dies ein Anzeichen für den Empfang eines beträchtlichen Störsignals. Sind die Pegel am vorderen Pegelmesser und am hinteren Pegelmesser gleich, dann ist dies ein Anzeichen dafür, daß das Nutzsignal ungestört ist.

Bei ungestörter Empfangssituation läßt der Prozessor - soweit keine Verzerrungen des Nutzsignals auftreten - das Dämpfungsglied unwirksam. Erst wenn der Pegel des Nutzsignals so groß ist, daß es verzerrt wird, schaltet der Prozessor das Dämpfungsglied ein.

Bei gestörter Empfangssituation stellt der Prozessor das Dämpfungsglied so ein, daß ein in dieser Empfangssituation bestmögliches Nutzsignal/Störsignal-Verhältnis erreicht wird.

In Ausgestaltung der Erfindung korrigiert der Prozessor bei gestörter Empfangssituation und einem absolut hohen Pegel am vorderen Pegelmesser die Abstimmung der Vorkreise aus Speicherwerten. Dadurch ist erreicht, daß die bei hohen Störpegeln auftretende Verstimmung der Vorkreise kompensiert wird.

Weitere vorteilhafte Ausgestaltungen der Erfindung ergeben sich aus den Unteransprüchen und der folgenden Beschreibung eines Ausführungsbeispiels. In der Zeichnung zeigen:

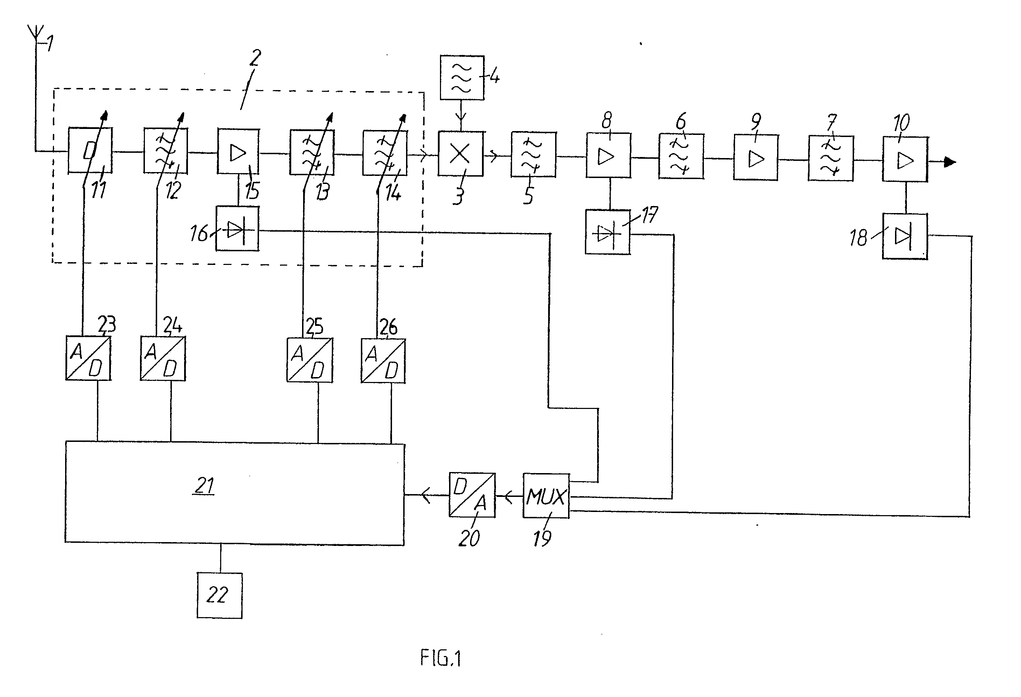

Figur 1 ein Teil-Blockschaltbild eines Hf-Überlagerungsempfängers, einschließlich des Zwischenfrequenz-Filters und

Figur 2 Signal-Frequenzdiagramme.

Ein Empfänger weist eine Antenne(1) auf. An diese ist eine Vorstufe(2) angeschlossen. Das Ausgangssignal der Vorstufe(2) liegt an einer Mischstufe(3), mit der ein Frequenzgenerator(4) verbunden ist. Der Mischstufe(3) sind drei Zwischenfrequenz-Filter(5,6,7) mit Verstärkern(8,9,10) nachgeschaltet. Die weitere, übliche Empfängerschaltung ist nicht näher dargestellt.

Die Vorstufe(2) weist eingangsseitig ein mittels Dioden einstellbares Dämpfungsglied(11) auf. Diesem sind mittels Kapazitätsdioden abstimmbare Vorkreise(12,13,14) nachgeschaltet. Zwischen dem ersten Vorkreis(12) und dem zweiten Vorkreis(13) liegt ein Verstärker(15). Der dritte Vorkreis(14) liegt ausgangsseitig an der Mischstufe(3).

An die Verstärker(15,8,10) sind von Gleichrichtern gebildete Pegelmesser(16,17,18) angeschlossen. Diese sind ausgangsseitig über einen Multiplexer(19) und einen Analog/Digital-Wandler-(20) mit einem Mikroprozessor(21) verbunden. Ein an den Mikroprozessor(21) angeschlossener Speicher(22) stellt diesem Speicherwerte zur Verfügung.

Der Mikroprozessor(21) steuert über einen Digital/Analog-Wandler(23) die Dämpfung des Dämpfungsgliedes(11). Er steuert außerdem über Digital/Analog-Wandler(24,25,26) die Einstellung der Resonanzfrequenzen der Vorkreise(12,13,14).

Die Wirkungsweise der beschriebenen Schaltung ist etwa folgende:
Der Mikroprozessor(21) erfaßt die von den Pegelmessern(16,17,18) ermittelten, der jeweiligen Empfangssituation entsprechenden Pegel in den unterschiedlichen Selektionsstufen, nämlich zwischen dem ersten und dem zweiten Vorkreis-(12,13), zwischen dem ersten und dem zweiten Zwischenfrequenz-Filter(5,6) und nach dem dritten Zwischenfrequenz-Filter(7). Er vergleicht die gemessenen Pegel miteinander und mit Speicherwerten aus dem Speicher(22). Er stellt dementsprechend über den Wandler(23) die Dämpfung des Dämpfungsgliedes(11) ein. Gegebenenfalls stimmt er über die Digital/Analog-Wandler(24,25,26) die Abstimmung der Vorkreise(12,13,14) nach.

Ist das Empfangssignal der Antenne(1) ungestört, dann werden die Pegel am Pegelmesser(16) und am Pegelmesser(17) bzw. am Pegelmesser-(18) im wesentlichen gleich sein. Der Mikroprozessor(21) stellt dann das Dämpfungsglied(11) so ein, daß es praktisch nicht dämpft. Erst wenn der Pegel an den Pegelmessern(16,17 bzw. 18) so hoch wird, daß eine Verzerrung des Nutzsignals eintritt, schaltet der Mikroprozessor(21) das Dämpfungsglied(11) auf eine gewisse Dämpfung. Er erkennt die Gefahr von Verzerrungen des ungestörten Eingangssignals durch Vergleich des Pegels am Pegelmesser(16) mit im Speicher(22) abgelegten Speicherwerten.

Tritt ein gestörtes Eingangssignal auf, dann ist der Pegel am vorderen Pegelmesser(16) wegen der dort noch geringen Frequenzselektion höher als der Pegel an den Pegelmessern(17 und/oder 18). Der Mikroprozessor(21) stellt dann am Dämpfungsglied(11) eine Dämpfung ein, die zu einem günstigen Nutzsignal/Störsignal-Verhältnis führt.

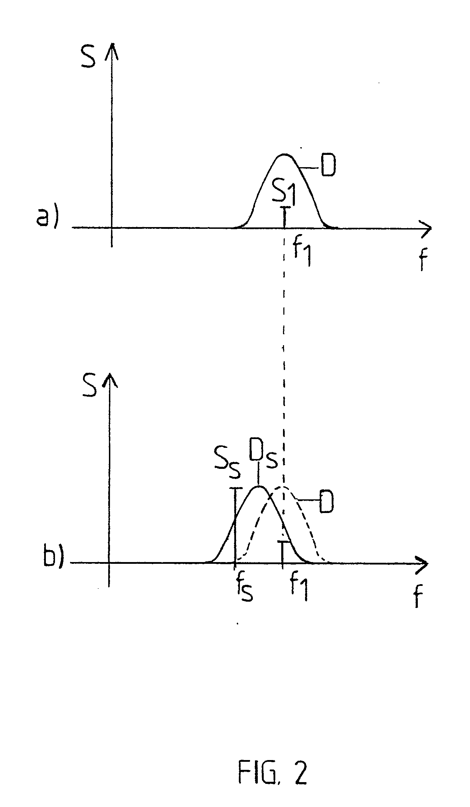

Die Durchlaßkurven(D) der Vorkreise(12,13,14) sind vom Mikroprozessor(21) entsprechend der Frequenz(f1) des jeweiligen Nutzsignals(S1) eingestellt (vgl. Figur 2a). Werden von der Antenne(1) absolut hohe Störsignale(Ss) mit der Frequenz(fs) empfangen, dann kann sich die Durchlaßkurve der Vorkreise(12,13,14) zur Störfrequenz(Fs) hin verschieben (vgl. Ds in Figur 2b). Der Mikroprozessor-(21) erkennt dies und stimmt in diesem Falle die Vorkreise(12,13,14) so nach, daß deren Durchlaßkurve(D) wieder die zur Nutzfrequenz(f1) symmetrische Lage einnimmt. Dies ist in Figur 2b strichliert gezeigt.

Es hat sich gezeigt, daß bei einem Empfänger mit einem Eingangspegelbereich zwischen 0,01 mV und 200 mV mit den beschriebenen drei Pegelmessern(16,17,18) Störpegel im Bereich einiger Volt noch sicher verarbeitet werden können. Der vordere Pegelmesser(16) reagiert unempfindlich, da er nahe am Eingang des Empfängers, also an einer Stelle liegt, an der die Verstärkung gering ist. Er dient dazu, sehr große Störsignale im Volt-Bereich zu erkennen.

Beim letzten Pegelmesser(18) liegt dagegen eine sehr hohe Verstärkung und auch eine starke Frequenzselektion vor. Entsprechend werden Störsignalanteile, die mehr oder weniger weit von der Empfangsfrequenz liegen, nicht erfaßt.

Am mittleren Pegelmesser(17) ist die Frequenzselektion geringer als am letzten Pegelmesser(18). Die Verstärkung ist schon so groß, daß beispielsweise Störsignale im 100 mV-Bereich erfaßt werden können. Es werden somit Störfrequenzen breitbandig erfaßt.

Bei anderen Empfängern, die beispielsweise einen noch größeren Eingangspegelbereich aufweisen, können auch mehr als drei Pegelmesser im Signalweg verteilt sein.

## Patentansprüche

1. Regelschaltung für eine elektronisch einstellbare Vorstufe eines Überlagerungsempfängers mit einem Prozessor, der über einen Digital/Analog-Wandler die im Signalweg zwischen einer Antenne und einem Zwischenfrequenz-Filter liegende Vorstufe steuert, dadurch gekennzeichnet, daß im Signalweg wenigstens zwei Pegelmesser-(16,17,18) liegen, wobei ein vorderer Pegelmesser(16) an einer Stelle geringer Selektion und ein hinterer Pegelmesser(17,18) hinter dem Zwischenfrequenz-Filter(5,6,7) angeordnet ist, daß der Prozessor(21) ein im Signalweg vor dem vorderen Pegelmesser(16) angeordnetes Dämpfungsglied(11) in Abhängigkeit von den Pegeln der Pegelmesser(16,17 bzw. 18) steuert, wobei der Prozessor(21) bei einem bezogen auf den Pegel am hinteren Pegelmesser(17 bzw. 18) hohen Pegel an dem vorderen Pegelmesser(16) die Dämpfung des Dämpfungsgliedes(11) so hoch einstellt, daß sich ein günstiges Nutzsignal/Störsignal-Verhältnis ergibt und der Prozessor(21) bei einem bezogen auf den Pegel am hinteren Pegelmesser(17 bzw. 18) etwa gleichen Pegel am vorderen Pegelmesser(16) die Dämpfung des Dämpfungsgliedes(11) reduziert.

(24,25,26) steuert.

2. Regelschaltung nach Anspruch 1, dadurch gekennzeichnet, daß der Prozessor(21) bei einem bezogen auf den Pegel am hinteren Pegelmesser(17 bzw. 18) etwa gleichen Pegel am vorderen Pegelmesser(16) eine Dämpfung des Dämpfungsgliedes(11) dann einschaltet, wenn Verzerrungen des Nutzsignals eintreten.

3. Regelschaltung nach Anspruch 1 oder 2, dadurch gekennzeichnet, daß der Prozessor(21) bei einem bezogen auf den Pegel am hinteren Pegelmesser(17 bzw. 18) hohen Pegel am vorderen Pegelmesser(16) und einem in diesem Fall absolut hohen Pegel am vorderen Pegelmesser(16) die Abstimmung der Vorkreise(12,13,14) der Vorstufe(2) aus Speicherwerten korrigiert.

4. Regelschaltung nach einem der vorhergehenden Ansprüche, dadurch gekennzeichnet, daß nach der Vorstufe(2) zwei Pegelmesser(17,18) vorgesehen sind.

5. Regelschaltung nach einem der vorhergehenden Ansprüche, dadurch gekennzeichnet, daß der vordere Pegelmesser(16) einem ersten Vorkreis(12) der Vorstufe(2) nachgeschaltet ist.

6. Regelschaltung nach Anspruch 5, dadurch gekennzeichnet, daß ein hinterer Pegelmesser-(17) zwischen einem ersten Zwischenfrequenz-Filter(5) und einem zweiten Zwischenfrequenz-Filter(6) liegt und daß ein weiterer Pegelmesser(18) hinter einem dritten Zwischenfrequenz-Filter(7) angeordnet ist.

7. Regelschaltung nach einem der vorhergehenden Ansprüche, dadurch gekennzeichnet, daß die Pegelmesser(16,17,18) über einen Multiplexer(19) und einen Analog/Digital-Wandler(20) an den Prozessor(21) angeschlossen sind.

8. Regelschaltung nach einem der vorhergehenden Ansprüche, dadurch gekennzeichnet, daß der Prozessor(21) das Dämpfungsglied(11) über einen Digital/Analog-Wandler(23) steuert.

9. Regelschaltung nach einem der vorhergehenden Ansprüche, dadurch gekennzeichnet, daß der Prozessor(21) die Vorkreise(12,13,14) der Vorstufe(2) über Digital/Analog-Wandler-

FIG.1

EP 0 455 974 A2

FIG. 2